(19) Europäisches Patentamt / European Patent Office / Office européen des brevets

(11) **EP 3 092 662 B1**

(12) **EUROPEAN PATENT SPECIFICATION**

(45) Date of publication and mention
of the grant of the patent:
**01.09.2021 Bulletin 2021/35**

(21) Application number: **15700102.5**

(22) Date of filing: **07.01.2015**

(51) Int Cl.:
*H01L 31/09* *(2006.01)*          *H01L 31/0232* *(2014.01)*
*H01L 31/0352* *(2006.01)*        *H01L 31/0224* *(2006.01)*
*H01L 27/144* *(2006.01)*

(86) International application number:
**PCT/EP2015/050174**

(87) International publication number:
**WO 2015/104294 (16.07.2015 Gazette 2015/28)**

(54) **SEMICONDUCTOR PHOTODETECTOR**

HALBLEITER-FOTODETEKTOR

PHOTODÉTECTEUR À SEMI-CONDUCTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.01.2014 EP 14305016**

(43) Date of publication of application:
**16.11.2016 Bulletin 2016/46**

(73) Proprietors:
• **Université Paris Diderot - Paris 7
75013 Paris (FR)**
• **Centre National de la Recherche Scientifique
(C.N.R.S.)
75016 Paris (FR)**

(72) Inventors:
• **CHEN, Yuk Nga
F-75014 Paris (FR)**
• **TODOROV, Yanko
F-92120 Montrouge (FR)**
• **SIRTORI, Carlo
F-75014 Paris (FR)**
• **MADEO, Julien
Okinawa, 904-0417 (JP)**

(74) Representative: **Regimbeau
20, rue de Chazelles
75847 Paris Cedex 17 (FR)**

(56) References cited:
**US-A- 5 773 831          US-A1- 2011 156 194
US-A1- 2013 320 470**

• **NGA CHEN YUK ET AL: "Antenna-coupled
microcavities for enhanced infrared
photo-detection", APPLIED PHYSICS LETTERS,
AMERICAN INSTITUTE OF PHYSICS, US, vol. 104,
no. 3, 031113, 23 January 2014 (2014-01-23),
pages 1-5, XP012181093, ISSN: 0003-6951, DOI:
10.1063/1.4862750**
• **MADÉO J ET AL: "Antenna-coupled
microcavities for terahertz emission", APPLIED
PHYSICS LETTERS, AMERICAN INSTITUTE OF
PHYSICS, US, vol. 104, no. 3, 20 January 2014
(2014-01-20), XP012181028, ISSN: 0003-6951,
DOI: 10.1063/1.4863055**
• **ALIREZA BONAKDAR AND HOOMAN MOHSENI:
"Hybrid optical antenna with high directivity
gain", OPTICS LETTERS, OPTICAL SOCIETY OF
AMERICA, vol. 38, no. 15, 1 August 2013
(2013-08-01), pages 2726-2728, XP001583729,
ISSN: 0146-9592, DOI:
HTTP://DX.DOI.ORG/10.1364/OL.38.002726**
• **None**

EP 3 092 662 B1

Printed by Jouve, 75001 PARIS (FR)

**Description**

TECHNICAL FIELD

The present application relates to a photodetector. It relates more particularly to a semiconductor photodetector with reduced thickness and advanced detection capability.

STATE OF THE ART

Existing photodetectors usually use a semiconductor layer in which carriers (either electron-holes pairs or electrons alone) are created when the detector is illuminated by an incident light beam to be detected. Then such electrons can be collected as a current indicative of the incident detected light beam intensity. In order to obtain enough light absorption to ensure an acceptable detection rate, such detectors usually need a semiconductor layer capable to absorb a considerable fraction of the light to be detected. It often results in detectors with a semiconductor thickness reaching at least a few micrometers.

In order to reduce the thickness of semiconductor photodetectors, devices have been designed that include reflecting means that make incident light cross the semiconducting layer several times. For example, some detectors use a mirror or a diffraction grating such as a Bragg lattice for reflecting the light that escapes the semiconducting layer back to it. Such reflecting means improve detectors sensitivity without increasing the thickness of the semiconducting layer. Nevertheless, they have an intrinsic thickness of at least a few wavelengths that prevent from reducing the thickness of such detectors below the wavelength of the light to be detected.

Therefore, in order to further reduce the thickness of photodetectors, new detectors have been proposed, taking advantage of another physical phenomenon: plasmon resonances. Such detectors exhibit a periodic array of metal stripes on top of a semiconducting layer. Plasmon resonances appear in this kind of structures when the period of the array is equal to the ratio between the wavelength of the light beam to be detected and the optical index of the semiconducting layer material. These resonances confine electromagnetic waves in the semiconducting layer under the metal strips, enabling the photodetector to capture the incident light beam and generate a photocurrent even with a very thin layer of semiconducting material.

Nevertheless, such detectors are very selective regarding the wavelength, the incidence angle and the polarization of the incident light beam.

In order to overcome these drawbacks (WO2010/072942) disclose theses detectors in which the semiconductor layer is sandwiched between a bottom metal plane and an array of metal strips. For such structures, the thickness of the semiconductor layer is much lower than the wavelength of the incident light beam. In such detectors, plasmon resonances appear between the metal strips and the bottom metal plane as long as the periodicity of the array remains lower than the ratio between the wavelength and the optical index of the layer. Such a structure acts as vertical optical cavity that confines the photons in the semiconducting layer under the strips and makes the photodetector less sensitive to the incidence angle of the light beam.

Moreover, a two-dimension array of square metallic pads can be used instead of strips in order to make absorption of the light beam by the detector independent of its polarization.

A typical feature of such detectors is that they are sensitive to thermal excitation of the electrons of the semiconducting material, which results in a current even without any incident light, called the dark current and a very low signal/noise ratio at room temperature. Consequently, such detectors can only be used at very low temperatures and require active cooling. The BLIP ("Background Limited Infrared Performance") temperature defines the maximum temperature for which the detection current produced by a 300K scene exceeds the dark current of the detector, which gives an idea of the maximal temperature at which the detector can be used. For instance, existing QWIP detectors ("Quantum Well Infrared Detector") operating at 2 $\mu$m, 9 $\mu$m and 18 $\mu$m have respectively a BLIP temperature equal to 200 K, 72 K and 45 K. Nga Chen Yuk et Al. in "Antenna-coupled microcavities for enhanced infrared photo-detection", APPLIED PHYSICS LETTERS, vol. 104, no. 3, (2014-01-23), pages 1-5, describes a photodetector comprising an array of metal pads.

US5773831 also describes describes a photodetector comprising an array of metal pads.

Thus there is a need for a photodetector thinner than the wavelength of the light beam to be detected, with little sensitivity to incidence angle and polarization, and less sensitive to thermal noise in order to be used at higher temperatures than usual.

SUMMARY OF THE INVENTION

In order to solve the aforementioned drawbacks, a photodetector as defined by the subject-matter of claim 1 is proposed for the detection of a light beam, comprising:

∘ A metal layer acting as a ground plane,

∘ A semiconductor layer covering the metal layer, wherein the semiconductor layer is made of a material having a quantum structure adapted for generating a detection current by absorbing the light beam bringing electrons from a fundamental state to an excited state,

∘ An array of metal pads covering the semiconductor layer, collecting the light beam and directing it towards the semiconductor layer,

wherein the semiconductor layer is etched in areas of the semiconductor layer that are not covered by a metal pad.

More particularly a photodetector is proposed for the detection of a light beam, comprising:

∘ A metal layer acting as a ground plane,

∘ A semiconductor layer covering the metal layer, wherein the semiconductor layer is made of at least two different materials forming an heterostructure adapted for generating a detection current by absorbing the light beam bringing electrons from a fundamental state to an excited state, the thickness of the semiconductor layer being equal or inferior to a wavelength of the light beam to be detected,

∘ An array of metal pads covering the semiconductor layer, collecting the light beam and directing it towards the semiconductor layer, each of the metal pads, together with the semiconductor layer and the metal layer underneath it, forming a vertical cavity type resonator, the metal pads being interconnected by metal connection strips for conducting the detection current,

Wherein the semiconductor layer is completely etched in areas of the semiconductor layer that are neither covered by the metal pads nor by the connection strips,

and wherein each metal pad forming an antenna for collecting incident photons of the light beam on an effective collection surface of the light twice larger than a physical collection surface of the semiconductor layer covered by said metal pad.

In other words, the metal pad and the semiconductor layer underneath it have the same surface A which is inferior to the effective collection of the light.

As the semiconductor layer is etched in the areas that are not covered by a metal pad or a connection strip, the area in which electrons can be excited by thermal excitation is reduced, which limits the dark current, without decreasing the amount of photons participating to the generation of the detection current. As a result, the photodetector has an improved signal/noise ratio and an increased BLIP temperature.

The pads may be formed periodically on the semiconductor layer, with a periodicity which is greater than the size of a pad along one of its dimensions, said size being equal to half of the ratio between a wavelength of the light beam to be detected and an optical index of the semiconductor layer material.

The pads may be formed periodically on the semiconductor, with a periodicity which is smaller than the wavelength of the light beam to be detected.

It enables to have plasmon resonances which confine the incident photons in the optical cavity formed inside the semiconductor layer under each metal pad, increasing the absorption of the photodetector.

The pads may be non-periodically formed on the semiconductor layer. The photodetector may comprise at least two areas with different pad periodicities or dimensions.

It enables detecting multiple wavelengths, one different wavelength being detected by each area of the device.

In one embodiment of the invention, the photodetector may comprise connection strips electrically connecting the pads together for conducting the detection current.

It enables using one pad as a single contact for collecting the detection current of the whole detector area.

Such connection strips may have a width which is greater than 100 nm.

The photodetector may comprise an electrical circuit enabling the readout of a current or a voltage induced by the photon absorption between the metal layer and the metal pads.

The photodetector may also comprise a voltage generator arranged for applying a voltage between the pads and the metal layer, the applied voltage causing a displacement of electrons in the semiconductor layer so as to generate the detection current.

In one embodiment of the invention, the metal pads are of rectangular shape.

Such a shape factor improves the ratio between the photon capture surface and the dark current generation surface and further decreases the dark current for a given detection current.

The orientation of each pad may be shifted of 90° in relation to adjacent pads.

If the pad is of rectangular shape A=sxw with s>w, then the lowest energy resonance of the structure has a resonant wavelength $\lambda_{res} = 2n_{eff}s$, where $n_{eff}$ is an effective index that is superior by 30% to the square root of the dielectric constant $\varepsilon$ of the detector material. That means that the structure will absorb light with a wavelength $\lambda_{res}$ and

with an electric field polarized along the side of length s. Thus, the structure acts as a resonant microcavity that is able to absorb and confine the incident light at a particular wavelength.

On the other hand, the same structure also acts as an antenna, characterized by an effective collection surface $\Sigma$. The initial effective surface $\Sigma$ for each pad (calculated when the pad is alone out of the array) is defined in such a way that, provided a uniform photon flux $\Phi$ incident on the structure, the total number of photons absorbed in the device per unit time is equal to $\Sigma\Phi$. For a single element, this surface can be expressed by the following formula:

$$(1) \qquad\qquad \Sigma = 4\lambda^2 Q_{loss}/(Q_{rad}D_{rad})$$

Here $\lambda$ is the wavelength to be detected, which is also the resonant wavelength of the structure, $Q_{loss}$ is the quality factor that describes the loss of photons by non-radiative mechanisms (i.e. absorption in the metal layers and in the detector region), $Q_{rad}$ is the quality factor that describes the radiation loss of the antenna. The quantity $D_{rad}$ is a coefficient called directivity that depends on the radiation pattern of the antenna, defined as $P_{rad}/dP_{rad}/d\Omega|_{max}$, that is the total radiated power divided by the peak power per unit solid angle.

With an appropriate choice of parameters we can have $\Sigma > A$, that is the area of collection of photons $\Sigma$ is larger than the area of the pad A. The function of antenna thus means that more light is collected to increase the photo current and therefore increase the signal/noise ratio, compared to the state of art.

The dimensions of the pads and their distance from each other allows to have an area of collection of photons $\Sigma'$ for each pad twice than the area A of the pad.

Advantageously, in a first embodiment, a surface S is covered by pads periodically arranged in an array, with an array surface cell $A_{cell}$ for each pad as represented on drawing 14, an initial effective collection surface of one single pad $\Sigma$, the array surface cell is defined by Acell = $\Sigma$/4, the effective total area where photons are collected being S.

Advantageously, $\Sigma = 4\lambda^2 Qloss/(QradDrad)$, wherein $\lambda$ is the wavelength to be detected, Qloss and Qrad being quality factors, Drad being a coefficient called directivity, the effective area of collection of light $\Sigma'$ of each pad is described by the formula:

$$(2) \qquad\qquad \Sigma' = \Sigma/(1+0.25* \Sigma/Acell)^2$$

Advantageously, at least one pad has dimensions such that incident photons are collected on an initial effective collection surface ($\Sigma$) calculated when the pad is alone, at least five times larger than the physical collection surface (A) of the semiconductor layer covered by said metal pad.

Advantageously, in a second embodiment, $A_{cell} > \Sigma/4$, the BLIP temperature of the detector being increased with respect to its intrinsic value $T_{BLIP}$ according to the formula :

$$(6) \qquad\qquad T_{BLIP}' = T_{BLIP}/(1- k_B\, T_{BLIP}\ln(\Sigma'/A)/E_{act})$$

($K_B$ is the Boltzman constant and $E_{act}$ is a thermal activation energy, A is the surface of the metal pad), and wherein $A_{cell}$ is fixed by the condition that the product of Eq.(2) and Eq.(6) is maximum.

Advantageously, at least one metal pad is square.

Advantageously, at least one metal pad is of rectangular shape with a length superior to a width.

Advantageously, the ratio between the length and the width of at least one rectangular pad is superior or equal to ten.

Advantageously, the photodetector comprises at least two rectangular pads having different spatial orientations, an angle between longitudinal directions of said pads being non-zero.

Advantageously, said angle between longitudinal directions of two rectangular pads is greater than 20°.

Advantageously, said angle between longitudinal directions of two rectangular pads is equal to 90°.

Advantageously, the direction of the length of said at least one rectangular pad is perpendicular to the metal connection strips.

Advantageously, the photodetector comprises at least two rows of pads, wherein the orientation of each pad is shifted of a non-zero angle greater than 20° in relation to adjacent pads belonging to a different row of pads.

Advantageously, the photodetector comprises at least one row of pads, wherein at least two rectangular pads are disposed crosswise on said row of pads.

The photodetector according to the invention comprises a patch antenna, and wherein at least one metal pad is connected to the patch antenna and the ground plane is a strip metal layer.

The photodetector according to the invention further comprises a substrate layer and two adjacent layer stacks mounted on the substrate layer, wherein a first layer stack comprises the metal layer, the semiconductor layer and the metal pads, and a second layer stack comprises an insulating layer and the patch antenna, said patch antenna being planar and disposed on said insulating layer, and facing at least one metal pad so as to focus incident photons on the vertical cavity type resonator.

Advantageously, the patch antenna comprises several elements. Advantageously, the several elements are disposed on either side of the pad. Advantageously, the patch antenna presents a spiral, loop, rectangular or bowtie shape.

Advantageously, the connection strips have a width lower than a fifth of the length of the metal pads.

Advantageously, the ground plane which is a ground layer is perpendicular to the connection strip.

In one embodiment, the length of the pads can be equal to half of the ratio between a wavelength of the light beam to be detected and an effective optical index of the semiconductor layer. Advantageously, the length of each pad along one of its dimensions ranges from 0.5 $\mu$m to 25 $\mu$m.

Instead of using a single pad, it is advantageous to use many pads in order to multiply the signal with the number of pads. Consider an embodiment of the invention where a surface S is covered by pads periodically arranged in an array with an array surface cell $A_{cell}$. Then it can be shown that the effective area of collection of light $\Sigma'$ of each pad is described by the formula:

$$(2) \qquad\qquad \Sigma' = \Sigma/(1+0.25{*}\Sigma/A_{cell})^2$$

However, the number of elements is $S/A_{cell}$, therefore the total signal is proportional to:

$$(3) \qquad\qquad S\Sigma'/A_{cell} = S\,(\Sigma/\,A_{cell})/(1+0.25{*}\Sigma/A_{cell})^2$$

An optimal detector would thus have the following characteristics: maximum collection area initial $\Sigma$ and minimal surface of the pad A. When a periodic array of pads is used, then $A_{cell}$ must be equal to $\Sigma/4$ and we have $\Sigma'=A_{cell}$. In that case all of the incident light power is funneled into the surface A, and there is no light reflected back from the detector surface.

In one embodiment of the invention, the pads are of rectangular shape with A=sxw. It can be shown that the effective area of collection can be modelled as $\Sigma=32n_{eff}wLQ_{loss}/\varepsilon$. Here $n_{eff}$ is the effective index of the resonant of the pad, $\varepsilon$ is the dielectric constant of the material of the semiconductor, and L is the thickness of the semiconductor region. In one embodiment of the device we have $s=w=1\mu$m, $n_{eff}=4$, $\varepsilon=10$, and $Q_{loss}=10$. It follows that $\Sigma=38\mu m^2$ and the array is optimized for $A_{cell} = 9\mu m^2$. In that case $\Sigma/A = 10$, that is tenfold increase in the signal to noise ratio with respect to a conventional device.

Thus, the used value of Acell can vary with an error margin of 10% preferably 5% from the calculated Acell=$\Sigma/4$.

At least one metal pad of the photodetector can be square or can be of rectangular shape, with a length superior to a width. The ratio between the length and the width of said rectangular pad may be superior or equal to two. This would allow to increase the number of elements in an optimized array.

A structure made of square pads sxs and a cavity resonance with a side equals to $\lambda_{res}/2n_{eff}$ has two degenerate modes that oscillate in two perpendicular directions. Such structure is therefore insensitive to the polarization of the incident light. A structure made of rectangular pads sxw with w<s will absorb a light with a wavelength $\lambda_{res}$ equal to $2n_{eff}S$ that is polarized only long the side s.

In one embodiment of the invention, the photodetector comprises at least two rectangular pads having different spatial orientations an angle between longitudinal directions of said pads being non-zero, for example greater than 20°.. The direction of the length of at least one rectangular pad may be perpendicular to the metal connection strips. The photodetector may comprise at least two rows of pads, wherein the orientation of each pad is shifted of a non-zero angle greater than 20° in relation to adjacent pads belonging to a different row of pads.

It makes the detector insensitive to polarization, even with rectangular pads.

In one embodiment, the photodetector may comprise at least one row of pads and at least two metal rectangular pads are disposed crosswise on said row of pads.

To increase the performance of the device, we therefore need to increase the collection surface $\Sigma$ while keeping the area of the cavity A minimal. This can be achieved by integrating the patch antenna configuration, described above, with additional elements.

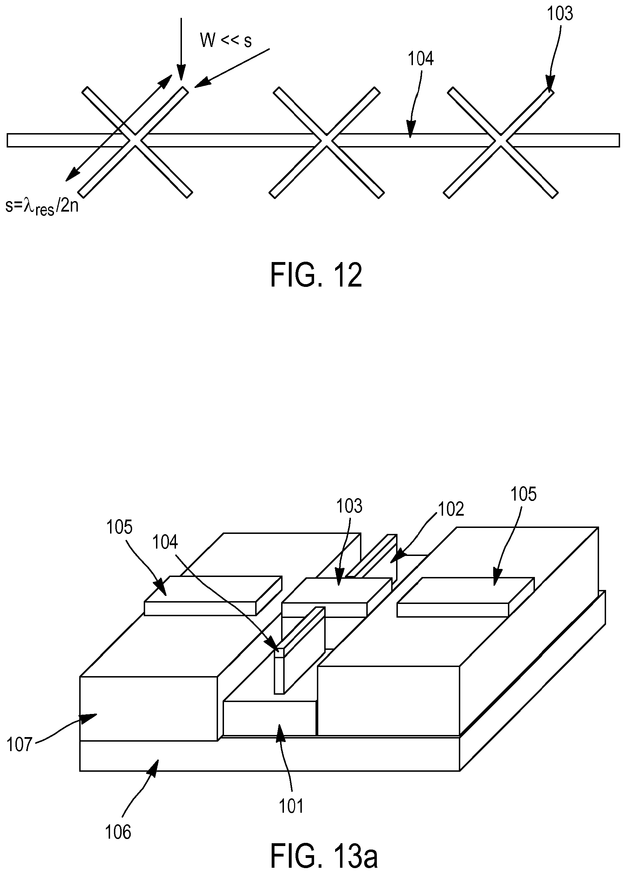

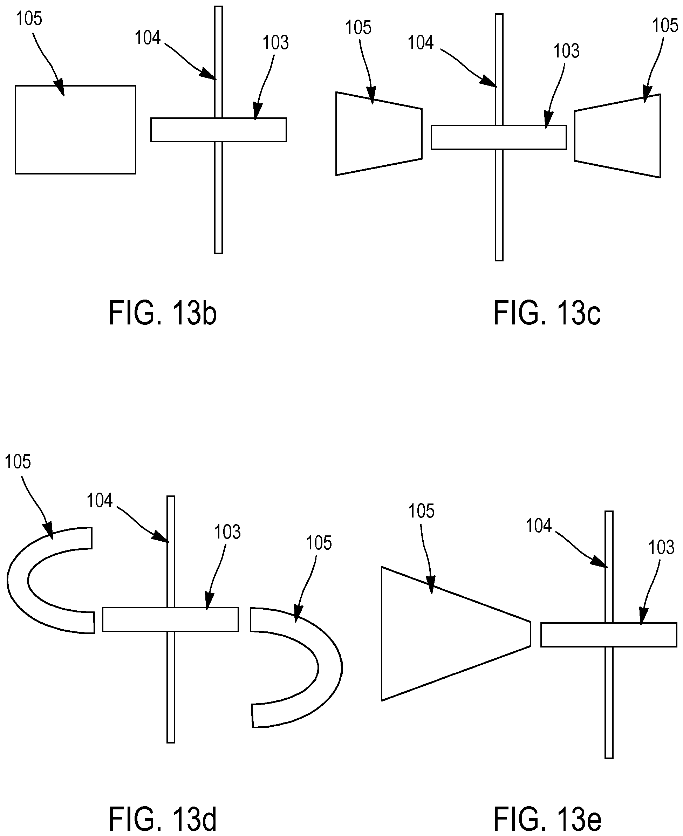

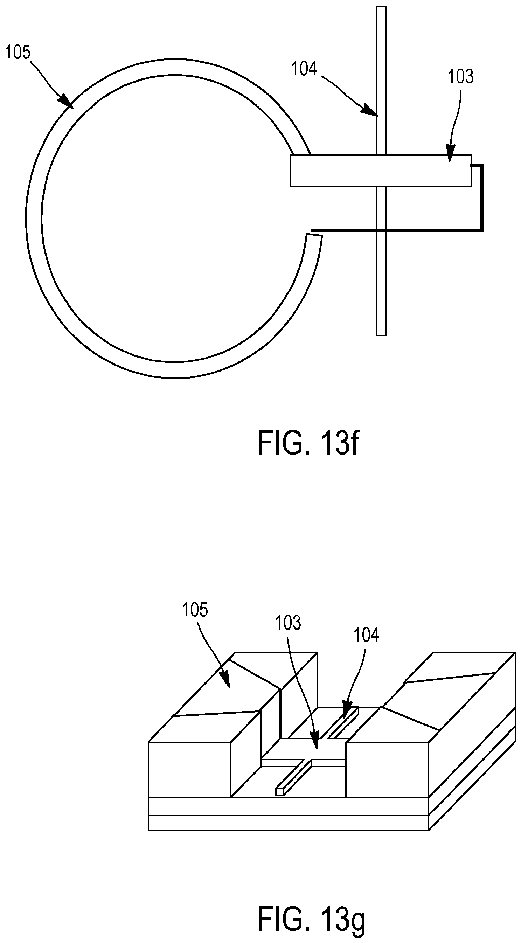

In one embodiment, described in figure 13, the metal ground is replaced with a metal strip. The detector region is kept above the strip, whereas insulating layers are disposed on both sides of the strip. Metal parts are disposed on the top of the insulating layers and the semiconductor. The metal parts on the top of the semiconductor form, together with the bottom metal strip, a microcavity as described above. On the other hand, the metal parts disposed on the insulating layers and not facing the metal ground acts as side antennas. When the distance between the top cavity metal pad and the side antennas is smaller than the resonant wavelength of the cavity, then there is a coupling effect between the side antennas and the micro cavity. Then the side antennas also collect light and funnel it inside the microcavity.

Such a configuration using an additional antenna enables further increasing the antenna effect gathering incident photons on the microcavity, therefore increasing the effective collection surface and the detection current without increasing the physical collection surface and the dark current. Indeed, in the case of side antennas the radiation quality factor $Q_{rad}$ is similar to the non-radiation $Q_{loss}$ factor, and the directivity $D_{rad}$ is close to 1. The initial effective area of such antenna is thus, accrding to Eq.(1) $\Sigma \sim \lambda^2 = 100 \mu m^2$ for a resonant wavelength $\lambda = 10 \mu m$.

Such planar side antenna may comprise several elements, which can be disposed on either side of the metal pad.

This can increase the electromagnetic field produced by the antenna in the vicinity of the pad and the associated focusing effect of the incident photons on the pad.

The patch antenna may present a spiral, loop, rectangular or bowtie shape.

The connection strips may have a width lower than a fifth of the length of the metal pads.

The length of each pad along one of its dimensions may range from 0.5 $\mu$m to 25 $\mu$m.

In summary, the present invention is about using structures that combine both antenna function and micro-cavity function for quantum detectors of radiation. The micro-cavity function allows to localize the electromagnetic filed, for a given resonant wavelength $\lambda_{res}$, in a well-defined volume of space with an area A=sw where a side s equals to $\lambda_{res}/2n_{eff}$ and w<s. The antenna function allows to collect photons from an effective area $\Sigma$ that can be much larger than the area of the detector A. This allows to increase the photocurrent, proportional to $\Sigma$, with respect to the dark current, proportional to A. When a periodic array of such elements is used, the array unit cell $A_{cell}$ must be set to $\Sigma/4$ for an optimal performance.

PRESENTATION OF THE DRAWINGS

Other characteristics and advantages will appear in the following description of embodiments of the invention. This description refers to figures in appendix among which:

- Figure 1 diagrammatically shows a structure of a photodetector not part of the invention (I, current; V, voltage);
- Figure 2 shows an array of metal pads and their connections;
- Figure 3 diagrammatically illustrates a step of etching the semiconductor layer;

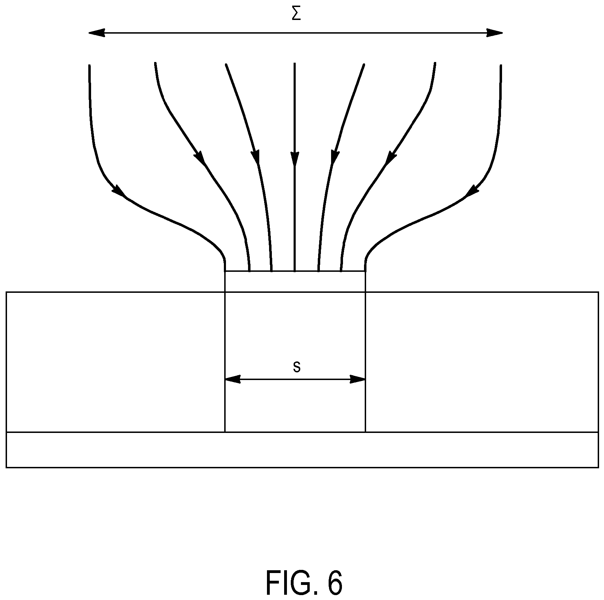

- Figures 4a et 4b, 5 and 6 show the effect of such etching on photons collection and the patch antenna effect of metal pads;
- Figure 7 describes the impact of etching on the dark current of the detector;
- Figure 8 shows the impact on the BLIP temperature of the detector;
- Figures 9a to 9c show the impact on the detector responsivity, reflectivity and sensitivity to the incidence angle of the photons;
- Figures 10 and 12 show additional examples of the metal pads;
- Figures 11a and 11b show the effect of rectangular pads on collection surfaces;
- Figures 13a to 13f show various embodiments for additional antenna elements;
- Figure 13g shows an example not part of the invention;

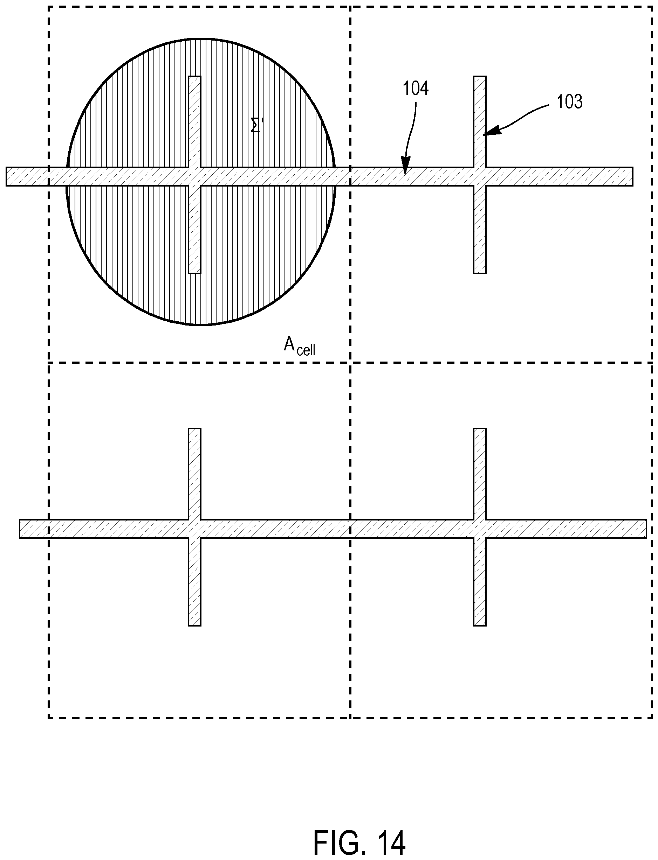

- Figure 14 shows a cell division of the photodetector surface for an array of antenna-coupled microcavities, with a schematic effective collection surface $\Sigma'$ (which can have another form)

DETAILED DESCRIPTION OF ONE EMBODIMENT

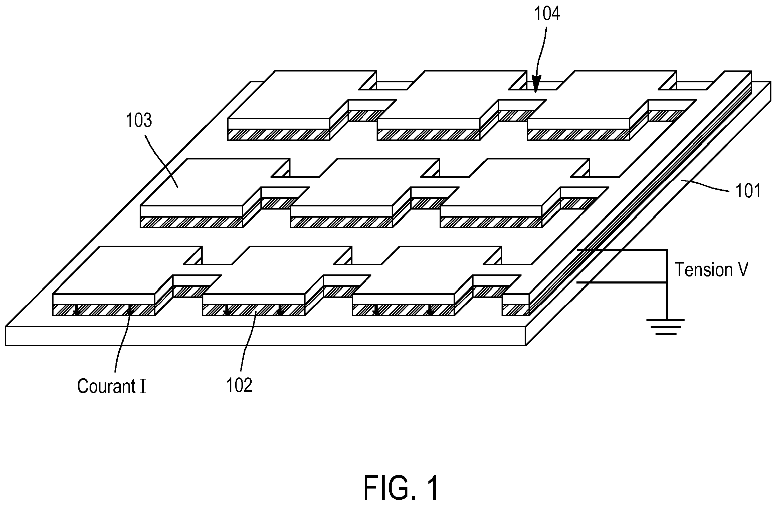

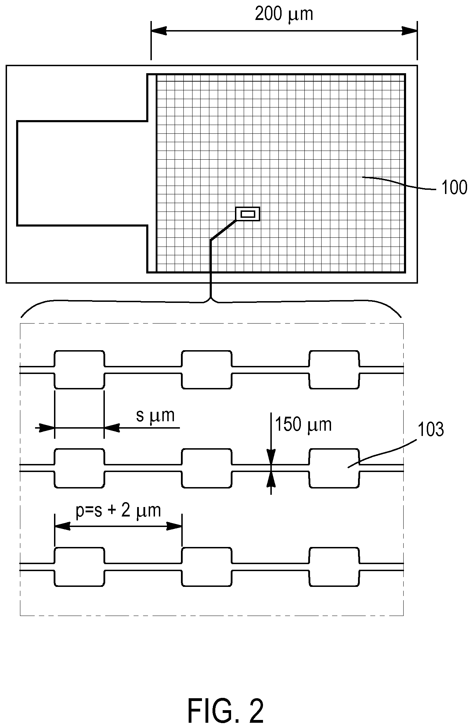

Figures 1 and 2 illustrate a photodetector for the detection of an incident light beam according to a possible embodiment of the invention. The photodetector is designed for a typical wavelength ranging from 5 $\mu$m to 300 $\mu$m, which makes it an infrared detector.

As depicted in Figure 1, such a photodetector comprises a metal layer 101 acting as a ground plane.

The photodetector also comprises a semiconductor layer 102 covering the metal layer. An additional intermediate layer may be used between the metal layer 101 and the semiconductor layer 102 in order to make the semiconductor layer grip on the metal layer. Such an intermediate layer can be made of titanium.

The semiconductor material is adapted for converting the energy of the incident photons into detection current. More precisely, the semiconductor material is composed of at least two different materials forming a quantum heterostructure in which electrons can be brought from a fundamental state to an excited state by displacement in the two materials. This excited state should be close to the bottom of the conduction band of the material that produces the quantum confinement ("barrier" material). For example, the difference between the excited state and the bottom of the conduction band should be lower than 5 meV. The incident photons excite the electrons from the fundamental to the upper state, and they escape into the conduction band. This process generates a photocurrent.

In one embodiment of the invention, the semiconductor layer is a QDIP ("Quantum Dot Infrared Photodetector") and in another embodiment, the semiconductor layer is QWIP ("Quantum Well Infrared Detector") structure.

When the semiconductor layer is a QWIP structure, such quantum structure comprises one or several quantum wells. The thickness of such quantum wells ranges preferably from 5 nm to 50 nm for detection wavelengths between 300 $\mu$m and 5 $\mu$m. The barriers between the quantum wells typically range from 20 nm to 100 nm. The width of the quantum wells determines the wavelength of the light beam that will be absorbed by the semiconductor material and thus that will be detected by the photodetector. The thickness of the semiconductor layer may be equal to the ratio between a wavelength of the light beam to be detected and an effective optical index of the semiconductor layer, thickness of the semiconductor layer may be inferior to the ratio between a wavelength of the light beam to be detected and an effective optical index of the semiconductor layer, thickness of the semiconductor layer may be equal or inferior to half of the ratio between a wavelength of the light beam to be detected and an effective optical index of the semiconductor layer. A photodetector according to this embodiment can be seen as a particular form of QWIP ("Quantum Well Infrared Detector"). According to one embodiment, this thickness is lower than a fourth of the ratio between the wavelength to be detected and the effective optical index of the semiconductor layer.

The photodetector also comprises an array of metal pads 103 covering the semiconductor layer. As a single pad is much smaller than the wavelength of the impinging radiation it would deliver a very small photocurrent signal. Therefore a large number of pads are employed to cover the area of the incident spot light, so that the overall photocurrent signal is multiplied by the total number of pads. The arrangement of the pads can be regular (periodic), with a periodicity which is preferably smaller than the wavelength of the light beam to be detected. However, the period can be increased above this wavelength, to have the largest possible collection surface, as long as diffraction effects have a negligible impact on the performance of the detector. The arrangement of the pads can also be non-regular (non-periodic). For instance, a single device can have two or more areas with different pad periodicities or dimensions, which will enable different wavelengths to be detected by different areas of the device.

Each pad can be used as a contact for collecting the detection current created by the absorption of the incident light beam in the semiconductor layer, between the base metal layer and the pad. The metal pads can be made of gold-titanium alloy, gold-germanium-nickel alloy or any other metallic alloy providing both an access resistance less than 1 ohm and a reflectivity close to one at the wavelength of the light beam to be detected. On the contrary, the base metal layer should have very little optical loss and should therefore be made out of a metal alloy with a reflectivity close to one at the wavelength of the light beam to be detected., The metal pads can be interconnected by metal connection strips 104 in order to provide a single contact for conducting the detection current. Such metal connection strips are disposed, between two metal pads, on top of the stack formed by the metal layer and the semiconductor layer or an insulating layer. The width of such connection strips is usually greater than 100 nm and significantly lower than the side length of the metal pads, for example lower than a fifth of it.

In another embodiment not drawn, the ground layer 101 is perpendicular to the connection strip 104.

In another embodiment not drawn, the connection strip 101 is disposed on an insulating layer.

In another embodiment not drawn, the connection strip 101 has a width equals to the length of the metal pads.

It is possible to combine these embodiments.

. The photodetector may also comprise an electric circuit that allows measuring the voltage or current generated by the displacement of electrons in the semiconductor layer owe to the absorption of a photon. In all cases, the current flows through the semiconductor between the top metal array comprising the pads and the connecting wires, and the bottom metal plane. The direction of the current is perpendicular to the semiconductor layer.

For instance, the photodetector may comprise a voltage generator arranged for applying a voltage between the pads and the metal layer, the applied voltage thus generating a detection current. Such an embodiment can be applied to detectors such as Quantum Well Infrared Photodetectors ("QWIP") described in an article by B. F. Levine, C. G. Bethea, G. Hasnain, V. 0. Shen, E. Pelve, R. R. Abbott, and S. I. Hsieh in Appl. Phys. Lett. 56, 851.

The same device geometry can be used without a voltage generator with semiconductor structures such as Quantum Cascade Detectors ("QCD") described in an article by L. Gendron, M. Carras, A. Huynh, V. Ortiz, C. Koeniguer and V. Berger in Appl. Phys. Lett. 85, 2824.

The length of each pad along one of its dimensions is smaller than the wavelength to be detected. In order to maximize the efficiency of the detector, it should be close to Lambda/2n, where Lambda is the absorption wavelength of the quantum structure of the detector and n is the effective optical index of the semiconductor layer. For example, such a length may range from 0.5 $\mu$m to 25 $\mu$m, depending on the wavelength of the light beam to be detected. Detectors with square pad sizes of 1.1, 0.95, 0.85 and 0.75 $\mu$m can for example be considered, 1.1 $\mu$m being the ideal pad size for detecting an incident light with a wavelength of 9 $\mu$m.

The thickness of the semiconductor layer is also lower than the wavelength to be detected. According to one embodiment, this thickness is lower than a fourth of the ratio between the wavelength to be detected and the optical index of the semiconductor layer material.

As a result of such a geometrical structure of the metal pads and the semiconductor layer, plasmon resonances appear. Each metal pad of the photodetector, together with the semiconductor layer and the metal layer underneath it, acts as a plasmonic resonator of vertical cavity type. Electromagnetic resonances appearing inside this structure confine the incident photons in the optical cavity formed inside the semiconductor layer under each metal pad, which increases the absorption of the photodetector despite the small thickness of its semiconductor layer.

Since the confined photons remain inside the semiconductor layer as long as they have not been absorbed, such a photodetector is able to deliver a strong detection current without requiring a thick layer of semiconductor layer for absorbing efficiently the incident light and producing this current.

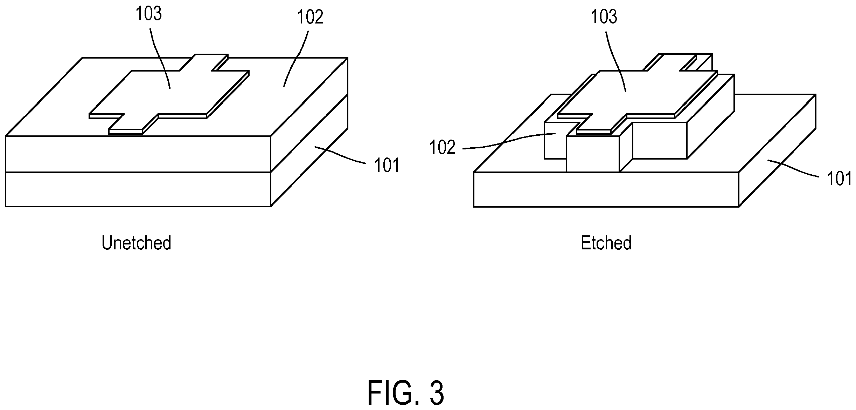

In order to lower the dark current of the detector and increase its BLIP temperature, the semiconductor layer is completely etched in areas of the semiconductor layer that are neither covered by a metal pad nor by a connection strip, as shown by Figures 1 and 3. In other words, each metal pad and the semiconductor layer underneath it present the same dimensions and are superimposed (or overlapped) exactly on a physical collection surface A, each pad being separated from the other pads and linked to at least one other pad by a metal connection strip. This metal connection strip consists in a metal sheet of given dimensions superimposed on a piece of the semiconductor layer having the same given dimensions mounted on the base metal layer.

A similar configuration could be obtained by other production processes. For example, instead of keeping the entire ground metal layer, the ground layer itself can be etched, so that small pads of semiconductor layer are stuck on the metal layer in a discontinued manner, only at locations of the detector where a metal pad or a connection strip is to be deposited in order to form the microcavities. The description given above is not limitative and the photodetector described here aims at covering any detector with a similar configuration obtained by any production process, using etching or not.

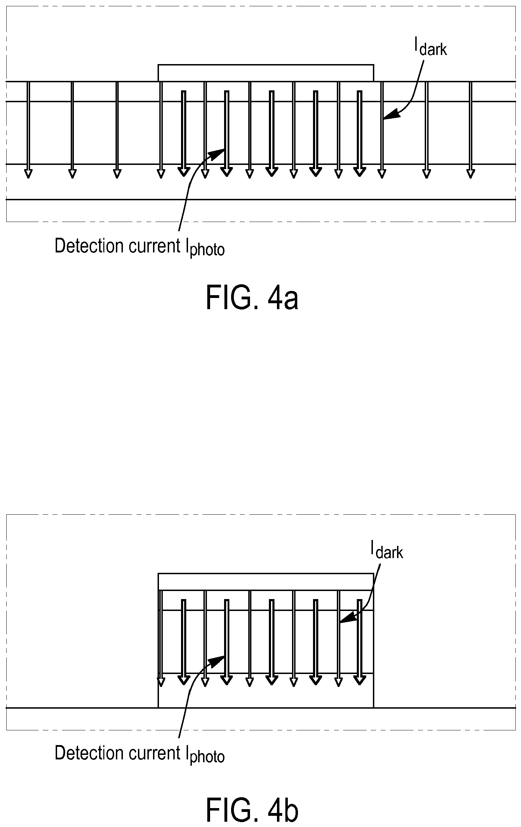

Since the dark current is proportional to the surface of the semiconductor layer, etching this layer decreases the area in which electrons can be excited thermally, which decreases the dark current, as shown by Figures 4a et 4b.

Decreasing the surface of semiconductor material generating the dark current would be useless if etching the semiconductor layer also decreased the surface across which incident photons are captured. Nevertheless, the structure of the detector allows decreasing the dark current by etching the semiconductor layer without decreasing the amount of photons participating to the generation of the detection current, compared to a similar unetched structure. Each metal-semiconductor-metal structure indeed acts as a patch antenna that focuses the incident light beam on a metal pad and directs it towards the semiconductor layer. Thus, incident photons of the light beam are collected on an effective collection surface $\Sigma$ much larger than the physical collection surface A of the semiconductor layer covered by said metal pad.

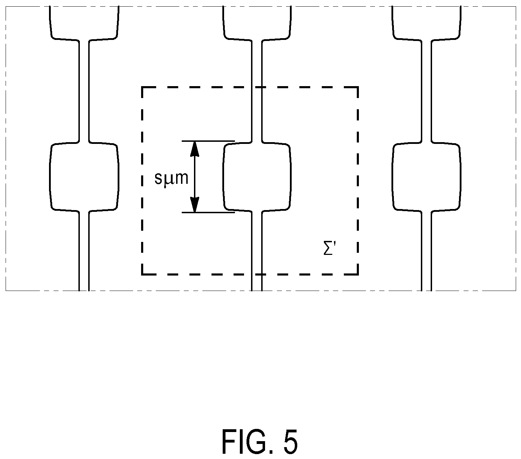

As shown by figures 5 6, and 14 representing an example in which each pad is of square shape whose side length equals s, though the etched semiconductor layer only covers a physical collection surface A under the pad, equal to $s^2$ for such a square pad, and the array unit cell is $A_{cell}=p^2$, equal to the square value of the period of the array p. In that case, the intrinsic initial collection area for each pad is equal to $\Sigma=38\mu m^2$, and the optimization of the photocurrent signal is expected at $A_{cell}=\Sigma/4 = 9\mu m$, that is $p=3\mu m$.

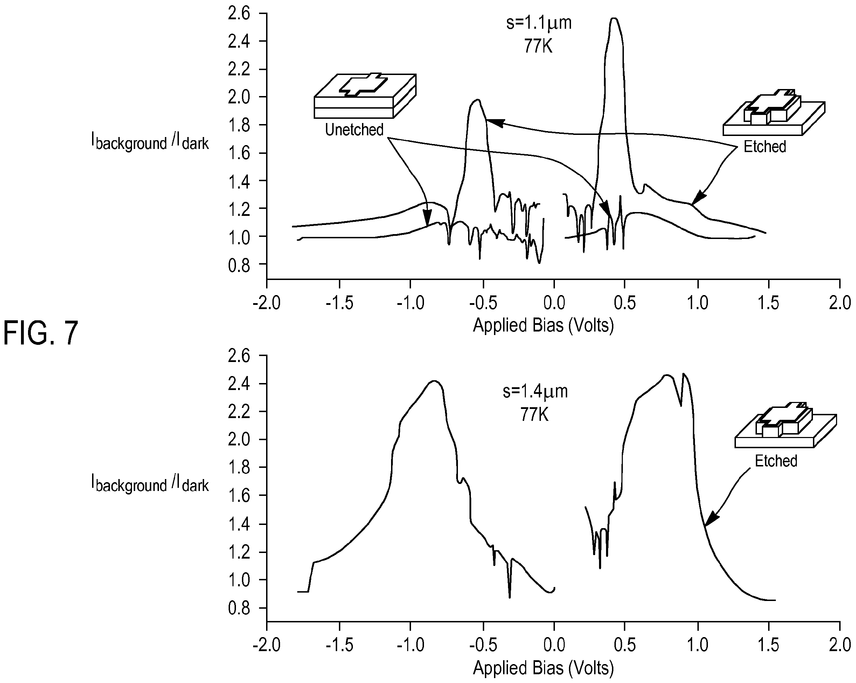

Therefore, in such a structure, photons are collected on a surface $A_{cell}=p^2$ much larger than the surface A generating the dark current, usually ten times larger. Since the detection current is proportional to the effective collection surface $A_{cell}$, the ratio between the detection current and the dark current is greatly improved. This improvement is shown by Figure 7 for different values of voltage applied by the voltage generator, I background being the sum of the dark current $I_{dark}$ and the detection current generated by a 300K scene. In the case of a pad size of 1.1 $\mu m$ the ratio Ibackground / $I_{dark}$ increases from 1.1 to 2.6 when etching the semiconductor layer. In the case where the pads are arranged into a non-regular (non-periodic) pattern, the role of Sigma can be played by the effective area of the pad, seen as a metallic quadrupolar antenna.

When the semiconductor is etched, the frequency of plasmon resonances is changed. For instance, a pad with s=1.1 $\mu m$ is resonant at 9 $\mu m$ before etching. After etching, a pad with s=1.4 $\mu m$ will be resonant at 9 $\mu m$. This change is due to the change in the effective refractive index of the mode n. Before etching, we have $n=n_{semiconductor} + 0.6$, where $n_{semiconductor}$ is the index of the semiconductor. This relation is not exact, but empirical as deduced from experiments and numerical simulations. After etching, n=nsemiconductor.

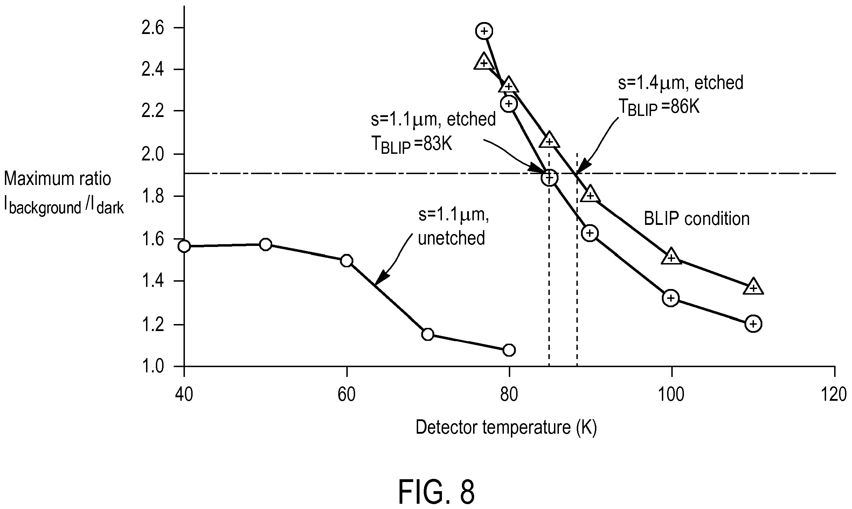

The main impact of etching the semiconductor layer is to increase the BLIP temperature as displayed by Figure 8. Before etching of the device, ("s=1.1 $\mu m$, unetched"), no BLIP condition is observed, as the dark current is too important. After etching of the device, ("s=1.1 $\mu m$, etched ", "s=1.4$\mu m$, etched "), the dark current is strongly reduced with respect to the photocurrent, and the BLIP temperature is increased up to 83-86K for different dimensions of the pads.

The gain in the detector BLIP temperature can be described by the following simplified model:

Let $I_{ph} = R_0 \Sigma \, \Phi$ be the collected photocurrent,

where

$R_0$ is constant, equal to the intrinsic responsivity of the detector.

$\Phi$ is the photon flux.

The thermally activated dark current is provided by $I_{dark}(T) = A\, J_{dark}\, exp(-E_{act}/k_B T)$, where T is the detector temperature,

$E_{act}$ is a thermal activation energy,
A is the detector area (surface of the metal pad),
$k_B$ is the Boltzmann constant.

Here we consider that $R_0$, $E_{act}$ and $J_{dark}$ are constants that depend on the detector design.

In a conventional design in the state of art, without etching, the effective collection surface of a pad is equal to its physical collection surface: $\Sigma = A$, and the BLIP temperature is provided by the equation:

$$(4) \quad I_{dark}(T_{BLIP}) = I_{ph}, \text{ ie } \quad A\, J_{dark}\, exp(-E_{act}/k_B\, T_{BLIP}). = R_0 A\Phi$$

For the antenna-effect microcavity presented here we have $A<<\Sigma'$ and the following equation holds for the new BLIP temperature $T_{BLIP}'$:

$$(5) \quad A\, J_{dark}\, exp(-E_{act}/k_B\, T_{BLIP}'). = R_0 \Sigma'\, \Phi$$

Here, in the case of an array with and array unit cell $A_{cell}$, the collection surface $\Sigma'$ is provided by the formula (2).

Using Equation (2) and Equation (1) we obtain the following link between $T_{BLIP}'$ and $T_{BLIP}$ :

$$(6) \quad T_{BLIP}' = T_{BLIP}/(1 - k_B\, T_{BLIP}\, ln(\Sigma'/A)/E_{act})$$

We can see from this equation that if we take $A<<\Sigma$ the BLIP temperature of the detector is always increased: $T_{BLIP}' > T_{BLIP}$.

As previously mentioned, according to an embodiment of the invention, the metal pads are of square shape. Such pads enable the detection of a light beam whatever its polarization may be.

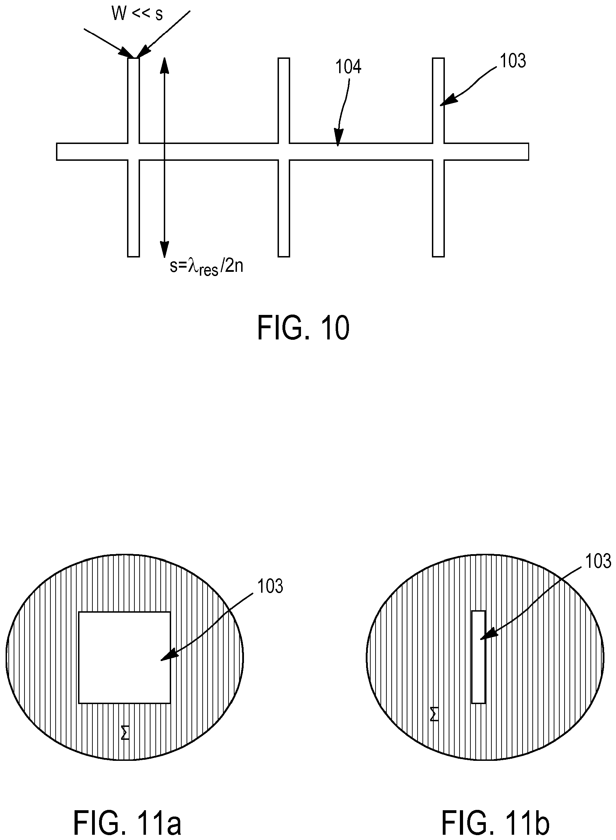

According to another embodiment, the metal pads are of rectangular shape with a length superior to a width. Advantageously, but in a non-limited way, as described in Figure 10 one of the dimensions of the pads, the length, is equal or close to $\lambda/2n$, where $\lambda$ is the wavelength to be detected and $n$ the effective optical index of the semiconductor. The other dimension, the width, is made very small as compared to the length. Such a length enables keeping the microcavity effect, while decreasing the width minimizes the physical collection surface A of the pad and the associated dark current.

Indeed, it appears from Eq.(2) and Eq.(6) that the case with higher BLIP is obtained for low density arrays such as $A_{cell} >> \Sigma$. The optimization of the collection efficiency and the temperature are therefore different issues, as the temperature is optimized in the limit of very diluted arrays, where $\Sigma'$ is close to its maximal initial value $\Sigma$. Therefore, depending on the applications, we one can choose to optimize either the collection efficiency, or the BLIP performance of the device.

For instance, for imaging applications in the Mid-Infrared range, it could be desirable to increase the collection efficiency, while actual cryo-free systems allow already operation at the BLIP temperature of the detector, at the liquid Nitrogen temperature (T=77 K).

On the contrary, in the THz range, the typical operation temperatures for quantum detectors are very low (T=4.5K). It is therefore desirable to increase the operating temperature of the device at maximum.

Provided an overall surface of the detector S (say, the area of a single pixel) when the array unit cell is $A_{cell}$ increased beyond $\Sigma/4$, the BLIP temperature is increased, according to Eq.(6), however the number of elements is $S/A_{cell}$, as well as the effective collection surface per element $\Sigma'$ are both decreased, according to Eq(6). For instance, if one places a single patch in the area S, we will have, according to Eq(2) and Eq(6), the highest possible $T'_{BLIP}$, yet the photo-current generated will be impractically small.

However, one can find unit point cell $A_{cell}$ such as $T'_{BLIP}$ and the area of collection are simultaneously optimized. Indeed, the function resulting from the multiplication of equations (6) and (3) always feature a maximum value for some unit cell $A_{cell0} > \Sigma/4$. At that point, the best possible compromise is obtained for a large (although not perfect) collection efficiency and a large $T'_{BLIP}$, for a given fixed total area S.

Furthermore, in the case of rectangular patches with A=sxw, the ratio $\Sigma/A = 32n_{eff}wLQ_{loss}/(ssw)$ $=64(n_{eff})^2 LQ_{loss}/(\varepsilon\lambda)$ is independent from the width of the patch $w$ (we have used that $s=0.5\lambda/n_{eff}$. This means that a rectangular patch with w<<s would have the same maximum possible $T'_{BLIP}$ (Eq.(6), when $\Sigma'=\Sigma$) as a square patch with w=s.

However, provided a detector area S, the same T'$_{BLIP}$ can be obtained by using rectangular or square pads.

However, in the case of rectangular patches, according to Eq.(6) this value is obtained with a smaller value of the unit cell, since $\Sigma$ is proportional to w. This means that the same T'$_{BLIP}$ can be obtained with a smaller unit cell A$_{cell}$ in the case of rectangular patches with (w«s) as compared to square patches (w=s), and, accordingly, the total number of elements (S/A$_{cell}$) is increased. With rectangular patches, we therefore obtain higher T'$_{BLIP}$ with an increased number of elements, and therefore higher photocurrent signal for a fixed total area S.

Consequently, using rectangular pads with high aspect ratio allows to increase the total number of elements for a given area S with the best possible T'$_{BLIP}$. Inversely, it allows to decrease the area S necessary to obtain the same level of photocurrent signal or BLIP performance as in the case of square pads. This fact allows the reduction of the pixel size for imaging applications.

In one embodiment, the length of at least one rectangular pad can be equal or superior to half of the ratio between a wavelength of the light beam to be detected and an effective optical index of the semiconductor layer, and the width of these rectangular pads can be inferior to half of the ratio between the wavelength of the light beam to be detected and the effective optical index of the semiconductor layer. For example, the ratio between the length and the width of a rectangular pad can be superior or equal to five, advantageously ten.

Nevertheless such rectangular pads make the detector sensitive to a particular polarization only.

Therefore, according to another embodiment of the invention, the photodetector can comprise at least two rectangular pads having different spatial orientations and forming a non-zero angle between their longitudinal directions. This angle can be greater than 20°. For example each rectangular pad can be shifted of 90° in relation to adjacent pads. The photodetector can also comprise at least two rows of pads, one row with rectangular pads in one direction and another row with rectangular pads in another direction. As a result the orientation of each pad can be shifted of a non-zero angle greater than 20° in relation to adjacent pads belonging to a different row of pads.

For example the orientation of each pad can be shifted of 90° in relation to adjacent pads belonging to a different row of pads. The direction of the length of at least one rectangular pad can be perpendicular to the metal connection strips.

In another embodiment, at least two metal pads can be disposed crosswise, in contact, orthogonally or not, for example forming a non-zero angle superior to 20°, on at least a row of pads, as shown in Figure 12.

The metal connection strips connecting such pads can be disposed symmetrically or not regarding the two rectangular pads.

Here on Figure 12, they are disposed where the metal pads are in contact.

Such features make the detector insensitive to polarization of the incident light beam, even with rectangular pads, while achieving a high ratio between the effective collection surface $\Sigma$ and the physical collection surface, in other words between the detection current and the dark current.

In one embodiment of the invention, all pads of the photodetector have the same dimensions.

In another embodiment of the invention, the photodetector comprises pads of at least two different dimensions in order to detect more than one wavelength in the incident light beam.

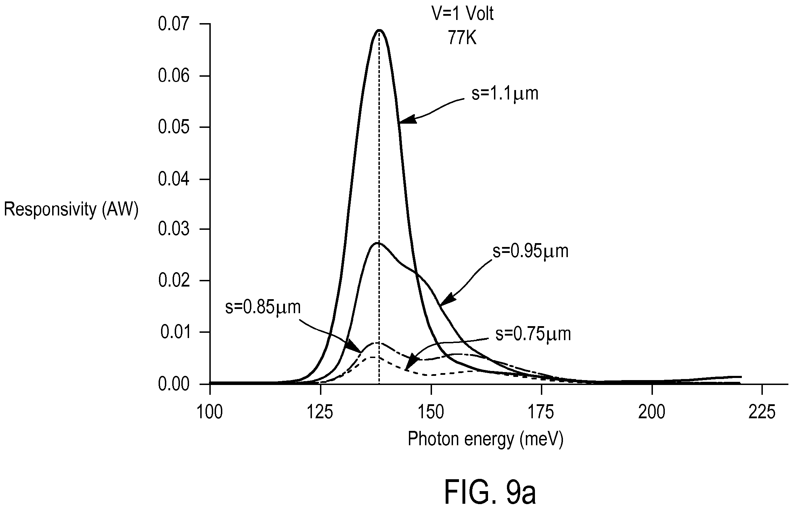

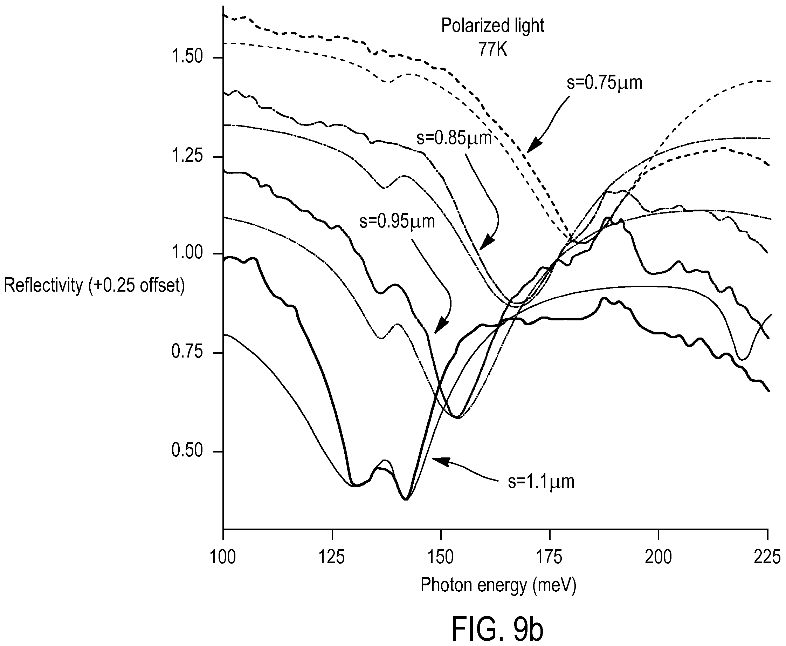

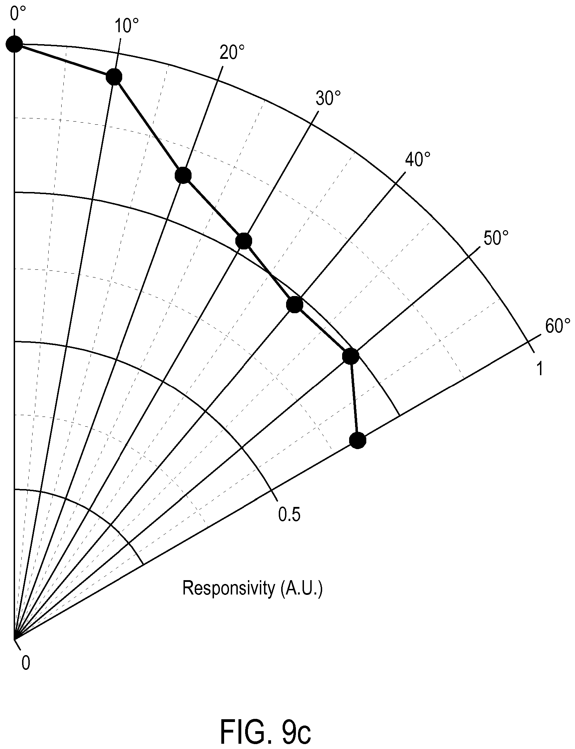

In an exemplary embodiment, the wavelength to be detected is 9 $\mu$m. The quantum structure of the semiconductor material comprises at least one GaAs quantum well whose thickness is 6.5 nm, cladded between 20nm Al$_{0.25}$Ga$_{0.75}$As barriers. In alternate embodiments, InGaAs/AlGeAs or InAs/AlSb structures can be used. The wells are Si-doped at sheet density $7.10^{11}$ cm$^{-2}$. The thickness of the semiconductor layer correspondingly ranges from 106.5 nm to 680 nm for an optical index of the material of 3.3. For example, if the absorbing material is a repeat of eight quantum wells, the total thickness of the semiconductor layer reaches 371.5 nm, taking into account top and bottom contacts which are Si-doped at $5.10^{18}$ cm$^{-2}$. Such a thickness is three to ten times smaller than the one of existing detectors. Metal pads are interconnected by 150 nm wide metal connection strips. The semiconductor layer can be bonded on a host substrate through annealed PdGeAu metallic layer, which serves both as the lower mirror of the microcavity and ohmic back-contact. The responsivity and reflectivity of such a detector are displayed for various pad dimensions on figures 9a and 9b, showing a main peak at the intersubband transition energy. Figure 9c shows the sensitivity of the detector to the incidence angle of the light beam, which proves to be very weak since the decrease of the sensitivity is kept lower than 40% between an incidence angle of 0° and 60°.

The effective area of collection of photons $\Sigma$ can be further increased by disposing an antenna comprising one or more antenna elements 105, such as a patch antenna, next to at least one metal pad, as described in Figure 13a. Indeed, the microcavity formed by the metal pad and the semiconductor and metal layers underneath it acts itself as an antenna that operates at the quadripolar order and has intrinsically a low collection efficiency. Planar antennas constituted by a single metal pad or two metal pads are intrinsically more efficient, as they operate on the dipolar order.

In other words, the architecture of the photodetector comprises microcavity elements formed by the metal ground, the semiconductor layer and the metal pads, that enhances the electromagnetic field around the absorbing medium, and antenna elements, that gather electromagnetic waves and funnel them into the microcavity elements. The antenna improves the effective collection surface $\Sigma$ on which the photons are gathered.

Such an antenna can be achieved with the present structure, for instance, by placing additional metal pads 105 on an insulating dielectric layer 107 next to the metal pad 103 of the microcavity. The elements of the antenna 105 can be in contact or not with the metal pad 103 of the microcavity.

For this embodiment, the ground plane 101 is etched with the semiconductor layer 102 for forming some strip layer just below the metal pad of the microcavity, in order to prevent the antenna elements from facing the metal ground plane.

In one embodiment represented in Figure 13a, the photodetector comprises a substrate layer 106 and two adjacent layer stacks mounted on the substrate layer. The first layer stack can comprise the metal layer 101, the semiconductor layer 102 and the metal pads 103, and a second layer stack can comprise an insulating layer 107 and the patch antenna 105, said patch antenna being planar and disposed on said insulating layer, and facing at least one metal pad so as to focus incident photons on the cavity formed by the metal pad.

Various antenna designs are represented in Figures 13a to 13g. The patch antenna can comprise a single element disposed on one side of the pad, such as on Figures 13b, 13e and 13f, or several elements disposed on either side of the pad, such as on Figures 13a, 13c, 13d and 13g. The patch antenna can be of various shapes such as a spiral (Figure 13d), loop (Figure 13f), rectangular (Figures 13a and 13b) or bowtie (Figure 13c and 13e) shape. In an example not part of the invention, the patch antenna can be a 3D antenna, such as the horn-type antenna described in Figure 13g. In that case, it can be disposed between two layers of dielectric material.

In order to maximize the focusing effect of the antenna, in a particular embodiment where the length of the metal pad of the cavity is perpendicular to the metal connection strips, the patch antenna can have an axis of symmetry perpendicular to the metal connection strips, and the patch antenna can be situated in the extension of the length of the pad, outwardly of the pad, such as depicted in Figures 13a, 13b, 13c, 13e and 13g.

In an embodiment, the pads 103 are formed periodically on the semiconductor,. When some side antenna is used, the effective collection surface of the pad is increased for a fixed wavelength.

The antenna can be formed periodically on the photodetector surface with the same periodicity as the metal pads. In order to maximize the efficiency of the photodetector, this periodicity can be similar to 1/4 of the antenna effective collection surface, for the wavelength of the light beam to be detected.

The antenna can also be formed non-periodically on the photodetector surface, for example if the metal pads are themselves non-periodically formed.

To conclude, such a photodetector enables to have a more compact structure than existing photodetectors, less sensitivity to the incidence angle, with a reduced dark current and an increased BLIP temperature. Reducing the thickness of the semiconductor layer also decreases the cost of the photodetector and the time needed for the epitaxial growth of the semiconductor. Furthermore, as the applied voltage is proportional to the device thickness, the reduction of the thickness also results in a reduced voltage, and therefore reduced power consumption of the device.

Though the previous paragraphs describe a photodetector directed towards the detection of a light beam whose wavelength is in the infrared domain, the same kind of structure can be used for detecting an electromagnetic beam in another frequency domain, for example in the Terahertz domain.

**Claims**

1. A photodetector for the detection of a light beam, comprising:

   ◦ a substrate layer and two adjacent layer stacks mounted on the substrate layer (106),
   ◦ wherein a first layer stack comprises

      ◦ a metal layer (101) acting as a ground plane,
      ◦ a semiconductor layer (102) covering the metal layer, wherein the semiconductor layer is made of at least two different materials forming an heterostructure adapted for generating a detection current by absorbing the light beam bringing electrons from a fundamental state to an excited state, the thickness of the semiconductor layer being inferior to a wavelength of the light beam to be detected,
      ◦ an array of metal pads (103) and metal connection strips (104) covering the semiconductor layer collecting the light beam and directing it towards the semiconductor layer, each of the metal pads, together with the semiconductor layer and the metal layer underneath it, forming a vertical cavity type resonator, the metal pads being interconnected by the metal connection strips (104) for conducting the detection current,
      wherein the semiconductor layer is completely etched in the areas of the semiconductor layer that are neither covered by the metal pads nor by the connection strips,
      and wherein each metal pad is forming an antenna for collecting incident photons of the light beam on an effective collection surface ($\Sigma'$) of the light at least twice larger than a physical collection surface (A) of the semiconductor layer covered by said metal pad,
**characterized in that**
◦ a second layer stack comprises:

◦ an insulating layer (107) and
◦ a patch antenna (105), said patch antenna being planar and disposed on said insulating layer, and facing at least one metal pad so as to focus incident photons on the vertical cavity type resonator, and wherein at least one metal pad is connected to the patch antenna and the ground plane is a strip metal layer.

2. The photodetector of claim 1, wherein at least one metal pad (103) is square.

3. The photodetector of claims 1 to 2, wherein at least one metal pad (103) is of rectangular shape with a length superior to a width.

4. The photodetector of claim 3, wherein the ratio between the length and the width of at least one rectangular pad is superior or equal to ten.

5. The photodetector of claim 3 or 4, comprising at least two rectangular pads having different spatial orientations, an angle between longitudinal directions of said pads being non-zero.

6. The photodetector of claim 5, wherein said angle between longitudinal directions of two rectangular pads is greater than 20°.

7. The photodetector of claim 6, wherein said angle between longitudinal directions of two rectangular pads is equal to 90°.

8. The photodetector of claims 3 to 7, wherein the direction of the length of said at least one rectangular pad is perpendicular to the metal connection strips.

9. The photodetector of claims 5 to 7 comprising at least two rows of pads, wherein the orientation of each pad is shifted of a non-zero angle greater than 20° in relation to adjacent pads belonging to a different row of pads.

10. The photodetector of claims 3 to 9, comprising at least one row of pads, wherein at least two rectangular pads are disposed crosswise on said row of pads.

11. The photodetector of claim 1, wherein the patch antenna comprises several elements (105).

12. The photodetector of claim 11, wherein the several elements (105) are disposed on either side of the pad.

13. The photodetector of any of claims 1 to 12, wherein the patch antenna presents a spiral, loop, rectangular or bowtie shape.

14. The photodetector of any of the preceding claims, wherein the connection strips (104) have a width lower than a fifth of the length of the metal pads.

15. The photodetector of any of the preceding claims, wherein the length of each pad along one of its dimensions ranges from 0.5 $\mu$m to 25 $\mu$m.

**Patentansprüche**

1. Photodetektor für die Detektion eines Lichtstrahls, der Folgendes umfasst:

◦ eine Substratschicht und zwei benachbarte Schichtstapel, die auf der Substratschicht (106) montiert sind,
◦ wobei ein erster Schichtstapel Folgendes umfasst
◦ eine Metallschicht (101), die als eine Erdungsplatte fungiert,
◦ eine Halbleiterschicht (102), die die Metallschicht abdeckt, wobei die Halbleiterschicht aus mindestens zwei verschiedenen Materialien besteht, die eine Heterostruktur bilden, die durch Absorbieren des Lichtstrahls, wodurch Elektronen aus einem Grundzustand in einen erregten Zustand versetzt werden, zum Erzeugen eines Detektionsstroms angepasst ist, wobei die Dicke der Halbleiterschicht kleiner ist als eine Wellenlänge des zu detektierenden Lichtstrahls,

◦ ein Array von Metallpads (103) und Verbindungsstreifen (104) aus Metall, die die Halbleiterschicht abdecken, den Lichtstrahl sammeln und zur Halbleiterschicht leiten, wobei jedes der Metallpads zusammen mit der Halbleiterschicht und der Metallschicht darunter einen vertikalen Hohlraumresonator bilden, wobei die Metallpads zum Leiten des Detektionsstroms durch die Verbindungsstreifen (104) aus Metall miteinander verbunden sind, wobei die Halbleiterschicht in den Bereichen der Halbleiterschicht, die weder von den Metallpads noch durch die Verbindungsstreifen abgedeckt sind, vollständig geätzt ist,

und wobei jedes Metallpad zum Sammeln von einfallenden Photonen des Lichtstrahls auf einer effektiven Sammelfläche ($\Sigma$') des Lichts, die mindestens zweimal größer ist als eine physische Sammelfläche (A) der Halbleiterschicht, die vom Metallpad abgedeckt wird, eine Antenne bildet,

**dadurch gekennzeichnet, dass**

◦ ein zweiter Schichtstapel Folgendes umfasst:

◦ eine Isolierschicht (107) und
◦ eine Patchantenne (105), wobei die Patchantenne planar und auf der Isolierschicht angeordnet sowie mindestens einem Metallpad zugewandt ist, um einfallende Photonen auf dem vertikalen Hohlraumresonator zu fokussieren,
und wobei mindestens ein Metallpad mit der Patchantenne verbunden und die Erdungsplatte eine Streifenmetallschicht ist.

2. Photodetektor nach Anspruch 1, wobei mindestens ein Metallpad (103) quadratisch ist.

3. Photodetektor nach den Ansprüchen 1 bis 2, wobei mindestens ein Metallpad (103) eine Rechteckform mit einer Länge, die größer ist als eine Breite, aufweist.

4. Photodetektor nach Anspruch 3, wobei das Verhältnis zwischen der Länge und der Breite von mindestens einem rechteckigen Pad größer als oder gleich zehn ist.

5. Photodetektor nach Anspruch 3 oder 4, der mindestens zwei rechteckige Pads mit verschiedenen räumlichen Ausrichtungen umfasst, wobei ein Winkel zwischen Längsrichtungen der Pads nicht null ist.

6. Photodetektor nach Anspruch 5, wobei der Winkel zwischen Längsrichtungen der zwei rechteckigen Pads größer als 20° ist.

7. Photodetektor nach Anspruch 6, wobei der Winkel zwischen Längsrichtungen der zwei rechteckigen Pads gleich 90° ist.

8. Photodetektor nach den Ansprüchen 3 bis 7, wobei die Richtung der Länge des mindestens einen rechteckigen Pads senkrecht zu den Verbindungsstreifen aus Metall verläuft.

9. Photodetektor nach den Ansprüchen 5 bis 7, der mindestens zwei Reihen Pads umfasst, wobei die Ausrichtung von jedem Pad mit Bezug auf benachbarte Pads, die zu einer anderen Reihe Pads gehören, um mehr als 20° aus einem Winkel von nicht null verschoben ist.

10. Photodetektor nach den Ansprüchen 3 bis 9, der mindestens eine Reihe Pads umfasst, wobei mindestens zwei rechteckige Pads kreuzweise auf der Reihe Pads angeordnet sind.

11. Photodetektor nach Anspruch 1, wobei die Patchantenne mehrere Elemente (105) umfasst.

12. Photodetektor nach Anspruch 11, wobei die mehreren Elemente (105) auf beiden Seiten des Pads angeordnet sind.

13. Photodetektor nach einem der Ansprüche 1 bis 12, wobei die Patchantenne eine Spiral-, Schleifen-, Rechteck- oder Fliegenform präsentiert.

14. Photodetektor nach einem der vorhergehenden Ansprüche, wobei die Verbindungsstreifen (104) eine Breite aufweisen, die kleiner ist als ein Fünftel der Länge der Metallpads.

**15.** Photodetektor nach einem der vorhergehenden Ansprüche, wobei die Länge von jedem Pad entlang einer seiner Abmessungen zwischen 0,5 $\mu$m und 25 $\mu$m beträgt.

**Revendications**

**1.** Photodétecteur pour la détection d'un faisceau lumineux comprenant :

une couche de substrat et deux empilements de couches adjacentes sur la couche de substrat (106), dans lequel un premier empilement de couches comprend :

une couche métallique (101) servant de plan de masse,
une couche semi-conductrice (102) recouvrant la couche métallique, dans lequel la couche semi-conductrice est réalisée avec au moins deux matériaux différents formant une hétérostructure adaptée pour générer un courant de détection en absorbant le faisceau lumineux faisant passer les électrons d'un état fondamental à un état excité, l'épaisseur de la couche semi-conductrice étant inférieure à une longueur d'onde du faisceau lumineux à détecter,
un ensemble de plots métalliques (103) et de bandes de connexion métalliques (104) recouvrant la couche semi-conductrice collectant le faisceau lumineux et le dirigeant vers la couche semi-conductrice, chacun des plots métalliques, conjointement avec la couche semi-conductrice et la couche métallique sous cette dernière, formant une résonateur de type à cavité verticale, les plots métalliques étant interconnectés par les bandes de connexion métalliques (104) pour conduire le courant de détection,
dans lequel la couche semi-conductrice est complètement gravée dans les zones de la couche semi-conductrice qui ne sont pas couvertes par les plots métalliques, ni par les bandes de connexion,
et dans lequel chaque plot métallique forme une antenne pour connecter les photons incidents du faisceau lumineux sur une surface de collecte effective ($\sum$') de la lumière au moins deux fois supérieure à une surface de collecte physique (A) de la couche semi-conductrice couverte par ledit plot métallique,
**caractérisé en ce que** :
un second empilement de couches comprend :

une couche isolante (107), et
une antenne à plaque (105), ladite antenne à plaque étant planaire et disposée sur ladite couche isolante, et faisant face à au moins un plot métallique afin de concentrer les photons incidents sur le résonateur de type à cavité verticale,
et dans lequel au moins un plot métallique est connecté à l'antenne à plaque et le plan de masse est une couche métallique de bande.

**2.** Photodétecteur selon la revendication 1, dans lequel au moins un plot métallique (103) est carré.

**3.** Photodétecteur selon la revendication 1 ou 2, dans lequel au moins un plot métallique (103) est de forme rectangulaire avec une longueur supérieure à une largeur.

**4.** Photodétecteur selon la revendication 3, dans lequel le rapport entre la longueur et la largeur d'au moins un plot rectangulaire est supérieur ou égal à dix.

**5.** Photodétecteur selon la revendication 3 ou 4, comprenant au moins deux plots rectangulaires ayant différentes orientations spatiales, un angle entre des directions longitudinales desdits plots étant non nul.

**6.** Photodétecteur selon la revendication 5, dans lequel ledit angle entre les directions longitudinales des deux plots rectangulaires est supérieur à 20°.

**7.** Photodétecteur selon la revendication 6, dans lequel ledit angle entre les directions longitudinales des deux plots rectangulaires est égal à 90°.

**8.** Photodétecteur selon les revendications 3 à 7, dans lequel la direction de la longueur dudit au moins un plot rectangulaire est perpendiculaire aux bandes de connexion métalliques.

**9.** Photodétecteur selon les revendications 5 à 7, comprenant au moins deux rangées de plots, dans lequel l'orientation de chaque plot est décalée à un angle non nul supérieur à 20° par rapport aux plots adjacents appartenant à une rangée différente de plots.

**10.** Photodétecteur selon les revendications 3 à 9, comprenant au moins une rangée de plots, dans lequel au moins deux plots rectangulaires sont disposés transversalement sur ladite rangée de plots.

**11.** Photodétecteur selon la revendication 1, dans lequel l'antenne à plaque comprend plusieurs éléments (105).

**12.** Photodétecteur selon la revendication 11, dans lequel la pluralité d'éléments (105) est disposée de chaque côté du plot.

**13.** Photodétecteur selon l'une quelconque des revendications 1 à 12, dans lequel l'antenne à plaque présente une forme de spirale, de boucle, rectangulaire ou de nœud papillon.

**14.** Photodétecteur selon l'une quelconque des revendications précédentes, dans lequel les bandes de connexion (104) ont une largeur inférieure à un cinquième de la longueur des plots métalliques.

**15.** Photodétecteur selon l'une quelconque des revendications précédentes, dans lequel la longueur de chaque plot le long de l'une de ses dimensions va de 0,5 $\mu$m à 25 $\mu$m.

FIG. 1

FIG. 2

103    102

101

Unetched

103

102

101

Etched

FIG. 3

EP 3 092 662 B1

$I_{dark}$

Detection current $I_{photo}$

## FIG. 4a

$I_{dark}$

Detection current $I_{photo}$

## FIG. 4b

FIG. 5

FIG. 6

FIG. 7

FIG. 8

FIG. 9a

FIG. 9b

EP 3 092 662 B1

FIG. 9c

FIG. 10

FIG. 11a

FIG. 11b

FIG. 12

FIG. 13a

FIG. 13b

FIG. 13c

FIG. 13d

FIG. 13e

FIG. 13f

FIG. 13g

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010072942 A

- US 5773831 A

**Non-patent literature cited in the description**

- **NGA CHEN YUK et al.** Antenna-coupled microcavities for enhanced infrared photo-detection. *APPLIED PHYSICS LETTERS,* 23 January 2014, vol. 104 (3), 1-5

- **B. F. LEVINE ; C. G. BETHEA ; G. HASNAIN ; V. 0. SHEN ; E. PELVE ; R. R. ABBOTT ; S. I. HSIEH.** *Appl. Phys. Lett.,* vol. 56, 851
- **L. GENDRON ; M. CARRAS ; A. HUYNH ; V. ORTIZ ; C. KOENIGUER ; V. BERGER.** *Appl. Phys. Lett.,* vol. 85, 2824